# EUROPÄISCHE PATENTSCHRIFT

(11) **EP 0 722 909 B1**
(45) Veröffentlichungstag und Bekanntmachung des Hinweises auf die Patenterteilung: **10.03.1999**
(21) Anmeldenummer: 95118914.1
(22) Anmeldetag: 01.12.1995
(51) Int. Cl.: C03B 19/14, C03B 37/014, C23C 16/44, B01J 4/00

(54) **Vorrichtung zur Aufteilung eines Gasstromes in mehrere Teilgasströme**
Device for splitting a gas stream into several partial gas streams
Dispositif pour la répartition d'un courant gazeux en plusieurs courants partials gazeux

(30) Priorität: 20.01.1995 DE 19501733
(43) Veröffentlichungstag der Anmeldung: 24.07.1996
(73) Patentinhaber: Heraeus Quarzglas GmbH, 63450 Hanau (DE)
(72) Erfinder: Bauscher, Heinz, D-63505 Langenselbold (DE); Ruppert, Klaus, Dr., D-63477 Maintal (DE)
(74) Vertreter: Kühn, Hans-Christian

(56) Entgegenhaltungen:
- EP-A- 0 476 218
- EP-A- 0 529 189
- WO-A-94/15707
- DE-A- 4 241 932
- GB-A- 2 277 327
- US-A- 5 368 062
- PATENT ABSTRACTS OF JAPAN vol. 13 no. 182 (C-591) ,27.April 1989 & JP-A-01 009821 (SHINETSU SEKIEI K.K.) 13.Januar 1989,
- PATENT ABSTRACTS OF JAPAN vol. 8 no. 184 (C-239) ,23.August 1984 & JP-A-59 080325 (FUJITSU K.K.) 9.Mai 1984,

## Beschreibung

Die Erfindung betrifft eine Vorrichtung zur Aufteilung eines Gasstromes in mehrere Teilgasströme, mit einer Ausgleichskammer, die einen Gaseinlaß mit mehreren Gaseinlaßöffnungen für den Gasstrom und mehrere, jeweils über eine Gasleitung mit einem Gasverbraucher verbundene Gasauslaßöffnungen für die Teilgasströme aufweist, wobei in Strömungsrichtung der Teilgasströme gesehen im Bereich unterhalb der Gasauslaßöffnungen für jeden Teilgasstrom der maximale Strömungswiderstand vorgesehen ist.

Eine derartige Vorrichtung, im folgenden als "Flußteiler" bezeichnet, ist aus der US-A 5,368,062 bekannt. Darin wird ein Versorgungssystem für ein korrosives Reaktionsgas bei der Halbleiterherstellung beschrieben. Das Gasversorgungssystem weist eine Reaktions- oder Mischkammer auf, in die verschiedene gasförmige Komponenten des Reaktionsgases eingeleitet werden. Die Reaktions- oder Mischkammer ist hierzu mit mehreren Gaseinlaßöffnungen und mit mehreren Gasauslaßöffnungen versehen. Die Gaseinlässe sind jewe5ils mit einem Massendurchflußreglern ausgestattet. Die Gasauslaßöffnungen sind mit elektromagnetischen Absperrventilen verbunden. Die Absperrventile sind entweder geöffnet oder geschlossen. Im geschlossenen Zustand wird die Gasströmung gesperrt. Darüberhinaus sind bei der bekannten Vorrichtung Maßnahmen zur reproduzierbaren Einstellung der Gasströmung im Bereich der Gasauslaßöffnungen nicht vorgesehen.

Aus der US-PS 5,116,400 ist ein Flußteiler beschrieben, der für die Gasversorgung einer Mehrfachbrenner-Anordnung mit Brennergasen eingesetzt wird. Die Mehrfachbrenner-Anordnung dient zum Abscheiden von SiO₂-Soot auf einem langgestreckten, um seine Längsachse rotierenden Trägerkörper. Die Brenner werden hierzu eine kurze Strecke, die etwa dem Brennerabstand entspricht entlang dem Trägerkörper axial hin und her geführt.

Zur Erzeugung eines homogenen Sootkörpers ist es wichtig, daß jeder Brenner die gleiche Aufbauleistung hat. Im Fall von Unterschieden in der Aufbauleistung der Brenner kommt es zu einer unregelmäßigen Außengeometrie des Soot-Körpers. Ungleiche Aufbauleistungen der einzelnen Brenner können auf Schwankungen in der Gasversorgung beruhen oder auf fertigungsbedingten Abweichungen von der idealen Brennergeometrie. Um für alle Brenner einer Mehrfachbrenner-Anordnung die gleiche Aufbauleistung zu gewährleisten, wird in der US-PS 5,116,400 vorgeschlagen, in der Gasversorgung ein Ausgleichsgefäß vorzusehen, das mit einem Gaseinlaß und mit einer der Anzahl der Brenner entsprechenden Zahl von Gasauslässen versehen ist. Dabei weist die Öffnung des Gaseinlasses einen größeren Öffnungsquerschnitt auf als die der jeweiligen Gasauslässe. Der Bereich des maximalen Druckabfalls ist demnach in demjenigen Bereich des Brenners vorzusehen, in dem sich die Brenner möglichst wenig unterscheiden. Dieser Bereich entspricht dann auch dem maximalen Strömungswiderstand der Gasversorgung.

Bei der Herstellung von Quarzglas mittels Soot-Abscheideverfahren werden häufig korrosive Medien, beispielsweise Silizium-Tetrachlorid (SiCl₄), benötigt. Brenner aus metallischem Werkstoff werden von diesen Medien chemisch angegriffen oder sie verziehen sich aufgrund der hohen Temperaturen. Üblicherweise bestehen die Brenner daher aus Quarzglas. Bei Quarzglasrohren ist es schwierig, den Innendurchmesser, und damit den maximalen Strömungswiderstand, exakt einzustellen.

Aber selbst geometrisch identische Brenner vorausgesetzt, gewährleistet die bekannte Vorrichtung nicht, daß zu jedem Zeitpunkt der Soot-Abscheidung alle Brenner relativ zueinander in etwa die gleiche Aufbauleistung aufweisen. Es hat sich gezeigt, daß innerhalb des Ausgleichgefäßes Druckdifferenzen auftreten, so daß an den Gasauslässen unterschiedliche Drücke anliegen. Dies führt bei geometrisch identischen Brennern zwangsläufig zu relativ zueinander unterschiedlichen Aufbauleistungen.

Infolge von Änderungen des durch den Gaseinlaß zugeführten Gasvolumens kann aber auch die absolute Abscheiderate aller Brenner im Verlauf des Sootkörper-Aufbaus variieren. Die herkömmliche Regelung der Brennergas-Zufuhr erfolgt über Rotameter oder über Massendurchflußregler (mass flow controller; MFC). Das Prinzip der Massendurchflußregelung beruht auf der Wärmeleitung des zu messenden Gasflusses. Temperaturänderungen im Bereich des MFC's oder Veränderungen des MFCs aufgrund von Korrosion durch aggressive Medien, wie beispielsweise SiCl₄, können eine zeitliche Drift der Regelung verursachen. Eine derartige Drift der den Brennern über MFCs geregelt zugeführten Gasmenge bewirkt eine Änderung der Abscheiderate aller Brenner und verursacht eine axiale Inhomogenität in der Mikrostruktur des Sootkörpers.

Der Erfindung liegt daher die Aufgabe zugrunde, eine Vorrichtung anzugeben, die einfach und kostengünstig herstellbar ist und die eine möglichst konstante und reproduzierbare Versorgung der Gasverbraucher mit Gas gewährleistet.

Diese Aufgabe wird ausgehend von dem eingangs erläuterten Flußteiler erfindungsgemäß dadurch gelöst, daß der maximale Strömungswiderstand für jeden Teilgasstrom in der Gasleitung zwischen der Gasauslaßöffnung und dem Gasverbraucher vorgesehen ist, und daß die Strömungswiderstände in die jeweiligen Gasleitungen auswechselbar eingesetzt sind.

Unter dem Ausdruck Gaseinlaß werden die für die Gasführung des in die Ausgleichskammer einzuleitenden Gasstromes notwendigen Bauteile einschließlich der bei der erfindungsgemäßen Vorrichtung erforderlichen Gaseinlaßöffnungen in der Wandung der Ausgleichskammer verstanden. Dadurch, daß der Gaseinlaß mehrere Gaseinlaßöffnungen umfaßt, ist es möglich, den in die Ausgleichskammer einströmenden Gasstrom auf mehrere kleinere, jeweils getrennt voneinander regelbare Teilströme aufzuteilen. Dadurch werden zeitliche Schwankungen oder Ungenauigkeiten der Teilströme herausgemittelt. Zumindest fallen derartige zeitliche Schwankungen oder Ungenauigkeiten einzelner Teilströme nicht so sehr ins Gewicht, wie dies bei nur einem Gasstrom der Fall ist. Die Ausbildung der Ausgleichskammer mit mehreren Gaseinlaßöffnungen ermöglicht außerdem eine Verteilung der Gaseinlaßöffnungen derart, daß ein möglichst kleiner Druckgradient innerhalb der Ausgleichskammer entsteht. Der Druckgradient ist umso größer, je größer der Abstand zwischen Gaseinlaß und Gasauslaßöffnung ist. Daher ist es insbesondere bei zylinderförmigen, langgestreckten Ausgleichskammern zur Vermeidung eines großen Druckgradienten erforderlich, statt eines zentralen Gaseinlasses mehrere Gasenlaßöffnungen für die Teilströme vorzusehen.

Unter der Ausgleichskammer wird dabei der gesamte zusammenhängende Hohlraum zwischen den Gaseinlaßöffnungen und den Gasauslaßöffnungen verstanden, innerhalb dem ein Ausgleich eventueller Druck-, Massen- oder Volumenunterschiede der einströmenden Teilströme möglich ist.

Dadurch, daß der maximale Strömungswiderstand für jeden Teilgasstrom in der Gasleitung zwischen den Gasauslaßöffnungen und den Verbrauchern vorgesehen ist, kann er an jeder Stelle der Gasleitung außerhalb des Gasverbrauchers angeordnet sein, insbesondere an Stellen mit geringer thermischer oder chemischer Belastung. Zudem ist durch die konstruktive Trennung von dem Verbraucher eine von diesem ausgehende Kontamination ausgeschlossen. Der Strömungswiderstand ist daher konstant. Er kann weiterhin aus einfach zu bearbeitenden Materialien hergestellt werden. Es ist nicht erforderlich, den jeweiligen Strömungswiderstand aus Quarzglas auszubilden; er ist daher genau einstellbar und in der Gasleitung auch leicht zugänglich.

Den maximalen Strömungswiderstand (im folgenden auch nur als "Strömungswiderstand" bezeichnet) bietet dabei die Gasleitung dort, wo der Druckabfall des jeweiligen Teilgasstromes maximal ist; dies ist grundsätzlich die Stelle mit dem kleinsten Öffnungsquerschnitt. Ein Teil der Gasleitung oder die gesamte Gasleitung kann beispielsweise den Strömungswiderstand bilden. Der Strömungswiderstand kann auch in die Gasleitung eingesetzt sein. Unter dem Ausdruck Gasleitung wird jede von einem Gas durchströmbare Verbindung zwischen den Gasauslaßöffnungen und den Gasverbrauchern verstanden. Jede Gasleitung kann aus einem oder aus mehreren Bauteilen bestehen. Mehrere Gasleitungen können miteinander verbunden sein, wobei dann vorteilhafterweise der maximale Strömungswiderstand für den jeweiligen Teilgasstrom in Strömungsrichtung gesehen unterhalb der Verbindungsstelle liegen sollte.

Bei der erfindungsgemäßen Vorrichtung, im folgenden wieder als "Flußteiler" bezeichnet, sind die Strömungswiderstände in die jeweiligen Gasleitungen auswechselbar eingesetzt. Besonders bewährt hierfür haben sich Strömungswiderstände in Form metallischer Bauteile. Die Bauteile weisen beispielsweise eine einfache Durchgangsbohrung auf. Die Durchgangsbohrung ist ohne großen Aufwand sehr genau herstellbar. Dadurch wird eine gute Reproduzierbarkeit des Strömungswiderstandes gewährleistet. Erforderlichenfalls ist die Durchgangsbohrung auch einfach zu vergrößern. Durch Anpassung aller Strömungswiderstände des Flußteilers an die konkreten Erfordernisse läßt sich der Flußteiler leicht optimieren. Dies ist beispielsweise bei der Abscheidung von SiO₂-Soot von mittels einer Mehrfachbrenner-Anordnung von Vorteil, wenn sich herausstellt, daß die Abscheiderate bei einzelnen Brennern vorteilhafterweise größer sein sollte als bei den benachbarten Brennern.

Es wird eine Ausführungsform des Flußteilers bevorzugt, bei der die Ausgleichskammer zylinderförmig ausgebildet ist und bei der die Gaseinlaßöffnungen in Längsachsenrichtung der Ausgleichskammer gesehen axial gleichmäßig verteilt sind. Die Länge der Ausgleichskammer wird entsprechend der geometrischen Verteilung der Gasverbraucher gewählt. Bei einer Anordnung der Verbraucher in einer Reihe kann es vorteilhaft sein, die Länge der Ausgleichskammer beispielsweise etwa so groß wie die Länge der Verbraucher-Reihe zu wählen. Die gleichmäßige Verteilung der Gaseinlaßöffnungen trägt zu einer homogenen Druckverteilung innerhalb der Ausgleichskammer bei.

Besonders bewährt hat sich ein Flußteiler, bei dem die Anzahl der Gaseinlaßöffnungen mit der Anzahl der Gasverbraucher und/oder mit der Anzahl der Gasauslaßöffnungen übereinstimmt. Dadurch ist es möglich, an den Gaseinlaßöffnungen diejenigen Gasströme definiert und geregelt bereitzustellen, die jedem einzelnen Gasverbraucher zugeführt werden sollen bzw. die die Gasauslaßöffnungen der Ausgleichskammer verlassen sollen.

Insbesondere im Hinblick auf einen bestmöglichen Druckausgleich und möglichst geringe Druckdifferenzen innerhalb der Ausgleichskammer hat es sich als vorteilhaft erwiesen, daß jeder Gaseinlaßöffnung mindestens eine Gasauslaßöffnung zugeordnet ist und daß jeweils der Abstand zwischen einer Gaseinlaßöffnung und der ihr zugeordneten Gasauslaßöffnung bzw. den ihr zugeordneten Gasauslaßöffnungen etwa gleich groß ist.

Als besonders günstig hat sich ein Flußteiler erwiesen, bei dem die Ausgleichskammer beheizbar ist. Die Beheizbarkeit ermöglicht das Einstellen einer Temperatur, bei der eine Kondensation der in der Ausgleichskammer enthaltenden Gase verhindert wird. Dabei kann es günstig sein, auch die Beheizbarkeit der von der Ausgleichskammer ausgehenden oder in sie einmündenden gasführenden Leitungen vorzusehen. Eine Kondensation innerhalb der Ausgleichskammer oder in den Leitungen kann zu einer Veränderung der Gasversorgung der Gasverbraucher führen.

Bei einer Ausführungsform des Flußteilers mit zylinderförmig ausgebildetem Ausgleichsgefäß hat sich ein Abstand der Gaseinlaßöffnungen im Bereich zwischen 10 cm und 50 cm als vorteilhaft erwiesen. Bei einem Abstand von mehr als 50 cm macht sich ein Druckgradient innerhalb der Ausgleichskammer bemerkbar. Ein Abstand von weniger als 10 cm trägt zur Verhinderung eines Druckgradienten nicht mehr wesentlich bei.

Als vorteilhaft, insbesondere im Hinblick auf eine Kostenersparnis für die Vorrichtung, hat sich eine Ausführungsform des Flußteilers erwiesen, bei dem der Ausgleichskammer durch jede Gaseinlaßöffnung gleichzeitig mehrere, getrennt voneinander regelbare Gasströme zuführbar sind. Im Fall, daß der Ausgleichskammer ein Gasgemisch zugeführt wird, ist es vorteilhaft, den Bereich der Mischung vor dem Gaseinlaß in die Ausgleichskammer, bzw. vor jeder Gaseinlaßöffnung vorzusehen.

Als besonders günstig hat es sich erwiesen, für eine Anzahl verschiedener, jeweils den Gasverbrauchern zuzuführender Gasströme eine gleiche Anzahl von Ausgleichskammern vorzusehen. Dabei wird üblicherweise jedem Gasverbraucher von jeder der Ausgleichskammern ein Teilgasstrom zugeführt. Eine derartige Ausführungsform des Flußteilers gewährleistet, daß jeder Teilgasstrom für sich reproduzierbar und konstant einstellbar und regelbar ist. Ausführungsbeispiele des erfindungsgemäßen Flußteilers sind in der Zeichnung dargestellt und werden nachfolgend näher erläutert. In der Zeichnung zeigen in schematischer Darstellung im einzelnen
- **Figur 1**: eine erste Ausführungsform eines Flußteilers mit gleicher Anzahl von Gaseinlaßöffnungen und Gasauslaßöffnungen,
- **Figur 2**: eine weitere Ausführungsform eines Flußteilers mit einer im Vergleich zur Ausführungsform von Figur 1 halbierten Anzahl von Gaseinlaßöffnungen,
- **Figur 3**: eine weitere Ausführungsform eines Flußteilers mit gleicher Anzahl von Gaseinlaßöffnungen und Gasauslaßöffnungen und
- **Figur 4**: eine weitere Ausführungsform eines Flußteilers.

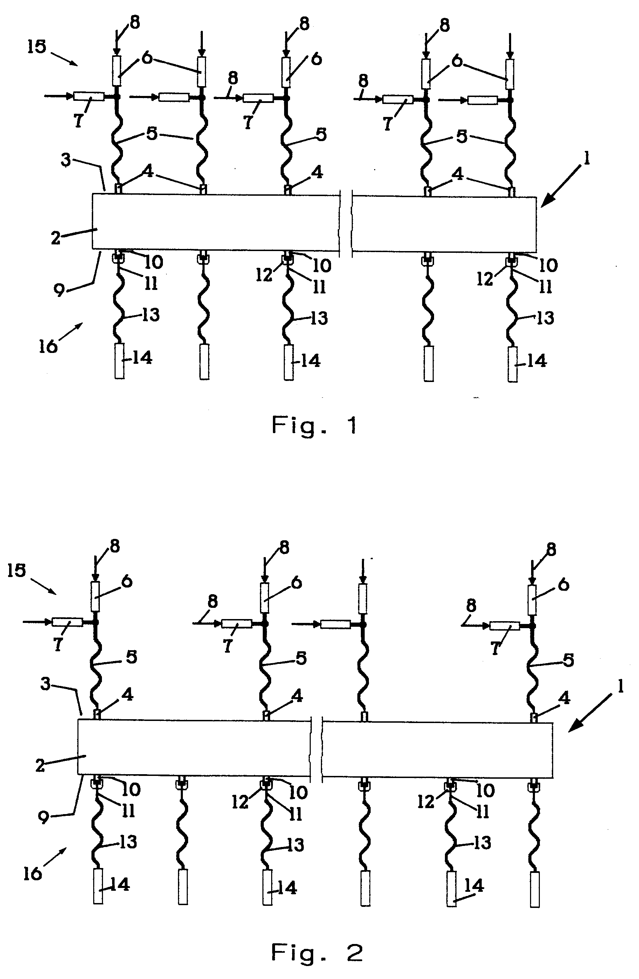

Bei den in den Figuren 1 bis 4 dargestellten Ausführungsformen ist dem erfindungsgemäßen Flußteiler jeweils die Bezugsziffer 1 zugeordnet. Bei der Ausführungsform des Flußteilers 1 gemäß Figur 1 ist ein rohrförmiges Ausgleichsgefäß 2 aus Edelstahl vorgesehen. An der Gaseinlaßseite 3 des Flußteilers 1 weist das Ausgleichsgefäß 2 in einem Abstand von ca. 15 cm zueinander angeordnete, mit Anschlußstutzen 4 versehene Bohrungen auf. (Die dem Ausgleichsgefäß 2 zugewandte Unterkante der Anschlußstutzen 4 stimmt mit der jeweiligen Bohrung in etwa überein). Jeder Anschlußstutzen 4 ist über einen Verbindungsschlauch 5 aus Polytetrafluorethylen (PTFE) mit einem Massendurchflußregler 6 für einen SiCl₄ -Gasfluß und mit einem Massendurchflußregler 7 für einen Sauerstoff-Gasfluß verbunden. Die Richtungspfeile 8 geben die Strömungsrichtung der genannten Gase an. Mit Gaseinlaß 15 sind nachfolgend die jeder Gasführung auf der Gaseinlaßseite 3 zugeordneten Bauteile 4; 5; 6; 7 und die entsprechende Gaseinlaßöffnung des Ausgleichsgefäßes 2 insgesamt bezeichnet. Über jeden Gaseinlaß 15 wird dem Ausgleichsgefäß 2 ein mittels der Massendurchflußregler 6; 7 vorgegebener Teilstrom des insgesamt in das Ausgleichsgefäß 2 eingeleiteten Gasstromes zugeführt.

An der Gasauslaßseite 9 des Flußteilers 1 weist das Ausgleichsgefäß 2 die gleiche Anzahl von Bohrungen auf wie an der Gaseinlaßseite 3. An die Bohrungen sind mit einem Außengewinde versehene Rohrstutzen 10 geschweißt. (Die dem Ausgleichsgefäß 2 zugewandte Oberkante der Rohrstutzen 10 stimmt mit der jeweiligen Bohrung in etwa überein). In jedem der Rohrstutzen 10 ist eine hülsenförmige Gasauslaßdüse 11, die mittels einer in das Außengewinde des Rohrstutzens 10 eingreifenden Überwurfmutter 12 mit diesem gasdicht verbunden ist, angeordnet. Die Gasauslaßdüse 11 besteht aus Edelstahl. Ihr Innendurchmesser ist auf +/- 5 µm genau gearbeitet. Die Gasauslaßdüsen 11 sind jeweils über gleich lange PTFE-Schläuche 13 an jeweils einen Aufbaubrenner 14 für Quarzglas-Soot gasdicht angeschlossen. Mit Gasleitung 16 sind nachfolgend die jeder Gasführung auf der Gasauslaßseite 9 zugeordneten Bauteile 10; 11; 12; 13 insgesamt bezeichnet.

Der Aufbaubrenner 14 besteht aus Quarzglas. Seine mit dem PTFE-Schlauch 13 verbundene Mitteldüse hat einen um ca. 30% größeren Innendurchmesser als die Gasauslaßdüse 11. Jeder Aufbaubrenner 14 weist zusätzliche Anschlüsse in Figur 1 (nicht dargestellt) für die weiteren Brennergase, wie Wasserstoff oder Sauerstoff, auf.

Nachfolgend wird die Wirkungsweise des erfindungsgemäßen Flußteilers anhand von Figur 1 näher erläutert. Zum Aufbau eines porösen Körpers aus SiO₂-Soot wird SiCl₄ verdampft und zusammen mit Sauerstoff als Trägergas über die Massendurchflußregler 6; 7 dem Ausgleichsgefäß 4 in einer vorgegebenen Strömungsrate geregelt zugeführt. Um Druckdifferenzen innerhalb des zylinderförmigen Ausgleichsgefäßes 2 zu verhindern, erfolgt die Zuführung der Gase über mehrere, über die Gaseinlaßseite 3 des Flußteilers 1 axial gleichmäßig verteilte Gaseinlässe 15. Die über die Gaseinlässe 15 in das Ausgleichsgefäß 2 einströmenden Gasflüsse sind etwa gleich groß. Eventuell vorhandene Unterschiede in den Gasflüssen können sich im Ausgleichsgefäß 2 ausgleichen. Innerhalb des Ausgleichsgefäßes 2 gibt es daher nur geringe Druckdifferenzen. An sämtlichen auf der Gasauslaßseite 9 gleichmäßig voneinander beabstandeten Rohrstutzen 10 liegt daher in etwa der gleiche Gasdruck an. Da die Innendurchmesser der Rohrstutzen 10 größer sind als die Innendurchmesser der in sie eingesetzten Gasauslaßdüsen 11 liegt auch an sämtlichen Gasauslaßdüsen 11 der gleiche Gasdruck an. Der Innendurchmesser der Gasauslaßdüsen 11 ist jeweils die engste Stelle der Gasleitungen 16, die das Ausgleichgefäß 2 mit jeweils einem Abscheidebrenner 14 verbinden. Die Gasauslaßdüsen 11 stellen daher in den Gasleitungen 16 den maximalen Strömungswiderstand dar; an ihnen erfolgt der maximale Druckabfall. Die Innendurchmesser der Gasauslaßdüsen 11 sind gleich und sehr genau gearbeitet. Infolgedessen sind die Strömungswiderstände für alle Gasleitungen 16 gleich groß, und auch die Gasströme in allen Gasleitungen 16 sind nach dem Verlassen der Gasauslaßdüsen 11 in etwa gleich. Somit erlauben die aus Edelstahl sehr genau einstellbaren Strömungswiderstände eine gute Reproduzierbarkeit der einzustellenden Gasströme und damit eine hohe Maßhaltigkeit der herzustellenden Soot-Körper.

Durch die konstruktive Trennung der Strömungswiderstände in Form der Gasauslaßdüsen 11 von den Abscheidebrennern 14 wird zudem eine von den Abscheidebrennern 14 ausgehende Kontamination und eine damit einhergehende Veränderung der Strömungswiderstände vermieden. Der erfindungsgemäße Flußteiler 1 zeichnet sich demzufolge auch durch eine zeitliche Konstanz der Strömungswiderstände aus, die sich in einer axialen Homogenität der herzustellenden Soot-Körper niederschlägt. Dieser Effekt wird im Vergleich zu dem aus dem Stand der Technik bekannten Flußteiler noch dadurch verstärkt, daß Schwankungen der Gaszufuhr infolge fehlerhafter oder driftender Massendurchflußregler 6; 7 aufgrund der Vielzahl der Gaseinlässe 16 ausgeglichen werden können.

Die in den Figuren 2 bis 4 verwendeten Bezugszeichen betreffen gleiche oder äquivalente Bauteile oder Bestandteile des Flußteilers 1 wie sie anhand der Ausführungsform in Figur 1 für die identischen Bezugszeichen erläutert sind. In der Figur 2 ist ein Flußteiler 1 gezeigt, bei dem gegenüber dem Flußteiler 1 gemäß Figur 1 die Anzahl der Gaseinlässe 15 etwa halbiert ist. Da somit auch nur die halbe Anzahl an Massendurchflußreglern 6; 7 erforderlich ist, ist die Ausführungsform gemäß Figur 2 kostengünstig. Nachteilig ist jedoch, daß durch den Abstand von 30 cm der Gaseinlässe 15 voneinander, in Abhängigkeit vom eingeleiteten Gesamt-Gasstrom, sich Druckdifferenzen innerhalb des Ausgleichsgefäßes 2 einstellen können.

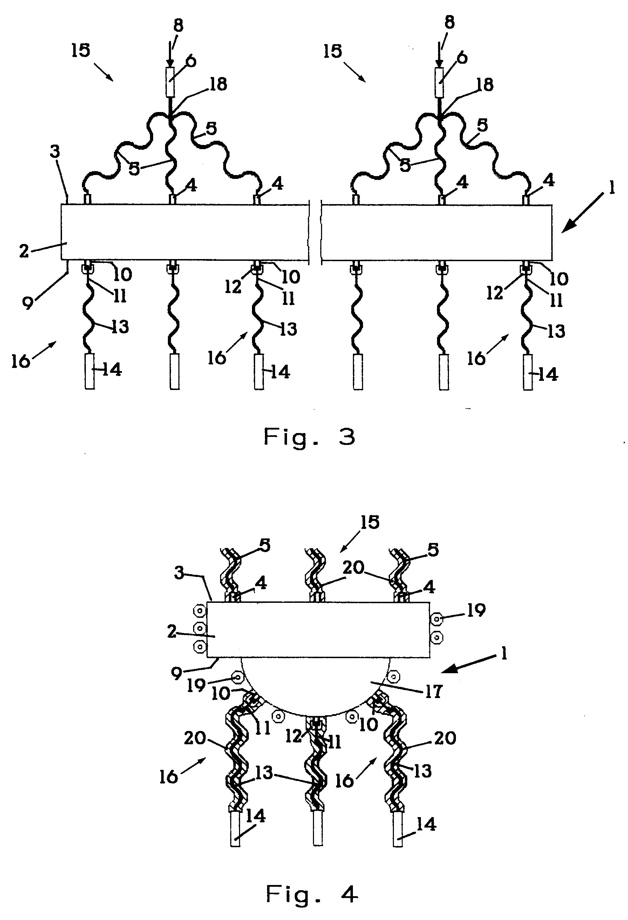

Im Unterschied zu der Ausführungsform gemäß Figur 2 ist bei der in Figur 3 dargestellten Ausführungsform des Flußteilers 1 nur jeweils ein Massenflußregler, nämlich für einen SiCl₄ -Gas strom, für jeden Gaseinlaß 15 vorgesehen. Hinsichtlich der Kostenersparnis für die Massendurchflußregler 6 hat diese Ausführungsform einen ähnlichen Effekt wie der in Figur 2 dargestellte Flußteiler 1. Sie vermeidet aber den genannten Nachteil, indem der Abstand der Gaseinlässe 15 voneinander mit 15 cm sehr gering gehalten wird. Hierzu ist jeweils bei jedem Gaseinlaß 15, in Strömungsrichtung 8 gesehen, in einem Bereich unterhalb der Massendurchflußregelung 6 eine Verzweigungsstelle 18 vorgesehen, von der mehrere, im Ausführungsbeispiel drei, PTFE-Verbindungsschläuche 5 abzweigen und über eine entsprechende Anzahl von Anschlußstutzen 4 in das Ausgleichsgefäß 2 einmünden. Für die Zuführung der übrigen Brennergase, wie Sauerstoff und Wasserstoff zu den Abscheidebrennern 14 wird, mit Ausnahme der an die jeweiligen Brennergase angepaßten Massendurchflußregler, jeweils die gleiche Vorrichtung eingesetzt, wie sie in Figur 3 für das Beispiel des SiCl₄ -Gasstromes erläutert ist.

Bei der in Figur 4 dargestellten Ausführungsform des erfindungsgemäßen Flußteilers 1 weist das im wesentlichen rechteckige Ausgleichgefäß 2 einen halbkugelförmigen Fortsatz 17 auf, an dem mehrere Gasleitungen 16 angeschlossen sind. Aufgrund der Kugelform ist an den Innenwandungen des Fortsatzes 17, und damit an den dort angeordneten Gasauslaßdüsen 11, eine optimal homogene Druckverteilung gewährleistet. Zur Vermeidung der Kondensation von SiCl₄ sind an der Außenwandung des Ausgleichsgefäßes 2 Heizschlangen 19 angebracht, mittels denen der Innenraum des Ausgleichgefäßes 2 auf einer Temperatur von mindestens 60 °C gehalten werden kann. Aus dem gleichen Grund sind die Gaseinlässe 15 und die Gasleitungen 16 mit Heizbändern 20 umwickelt.

## Patentansprüche

1. Vorrichtung zur Aufteilung eines Gasstromes in mehrere Teilgasströme, mit einer Ausgleichskammer (2), die einen Gaseinlaß (15) mit mehreren Gaseinlaßöffnungen (4) für den Gasstrom und mehrere, jeweils über eine Gasleitung (16) mit einem Gasverbraucher (14) verbundene Gasauslaßöffnungen (10) für die Teilgasströme aufweist, wobei in Strömungsrichtung (8) der Teilgasströme gesehen im Bereich unterhalb der Gasauslaßöffnungen (10) für jeden Teilgasstrom der maximale Strömungswiderstand (11) vorgesehen ist, dadurch gekennzeichnet, daß der maximale Strömungswiderstand (11) für jeden Teilgasstrom in der Gasleitung (16) zwischen der Gasauslaßöffnung (10) und dem Gasverbraucher (14) vorgesehen ist, und daß die Strömungswiderstände (11) in die jeweiligen Gasleitungen (16) auswechselbar eingesetzt sind.

2. Vorrichtung nach Anspruch 1, dadurch gekennzeichnet, daß die Strömungswiderstände (11) jeweils in Form eines metallischen Bauteils ausgeführt sind.

3. Vorrichtung nach einem der vorhergehenden Ansprüche, dadurch gekennzeichnet, daß die Ausgleichskammer (2) zylinderförmig ausgebildet ist und daß die Gaseinlaßöffnungen (4) in Längsachsenrichtung der Ausgleichskammer (2) gesehen axial gleichmäßig verteilt sind.

4. Vorrichtung nach einem der vorhergehenden Ansprüche, dadurch gekennzeichnet, daß die Anzahl der Gaseinlaßöffnungen (4) mit der Anzahl der Verbraucher (14) und /oder mit der Anzahl der Gasauslaßöffnungen (10) übereinstimmt.

5. Vorrichtung nach einem der vorhergehenden Ansprüche, dadurch gekennzeichnet, daß jeder Gaseinlaßöffnung (4) mindestens eine Gasauslaßöffnung (10) zugeordnet ist und daß jeweils der Abstand zwischen einer Gaseinlaßöffnung (4) und der ihr zugeordneten Gasauslaßöffnung (10) bzw. den ihr zugeordneten Gasauslaßöffnungen (10) etwa gleich groß ist.

6. Vorrichtung nach einem der vorhergehenden Ansprüche, dadurch gekennzeichnet, daß die Ausgleichskammer (2) beheizbar ausgebildet ist.

7. Vorrichtung nach einem der vorhergehenden Ansprüche, dadurch gekennzeichnet, daß die Ausgleichskammer (2) zylinderförmig ausgebildet ist und der Abstand benachbarter Gaseinlaßöffnungen (4) im Bereich zwischen 10 cm und 50 cm liegt.

8. Vorrichtung nach einem der vorhergehenden Ansprüche, dadurch gekennzeichnet, daß der Ausgleichskammer (2) durch jede Gaseinlaßöffnung (4) gleichzeitig mehrere, getrennt voneinander regelbare Gaströme zuführbar sind.

9. Vorrichtung nach einem der vorhergehenden Ansprüche, dadurch gekennzeichnet, daß für eine Anzahl verschiedener, jeweils den Gasverbrauchern (14) zuzuführender Gasströme eine gleiche Anzahl von Ausgleichskammern (2) vorgesehen ist.

## Claims

1. A device for dividing a gas stream into several partial gas streams, with an equalizing chamber (2) which has a gas inlet (15) with several gas inlet openings (4) for the gas stream and several gas outlet openings (10) for the partial gas streams respectively connected via a gas duct (16) with a gas consumer (14), wherein viewed in flow direction (8) of the partial gas streams, in the region beneath the gas outlet openings (10) for each partial gas stream the maximum flow resistance (11) is provided, characterised in that the maximum flow resistance (11) for each partial gas stream in the gas duct (16) is provided between the gas outlet opening (10) and the gas consumer (14), and that the flow resistances (11) are inserted into the respective gas ducts (16) so as to be exchangeable.

2. A device according to Claim 1, characterised in that the flow resistances (11) are respectively constructed in the form of a metallic component.

3. A device according to one of the preceding claims, characterised in that the equalizing chamber (2) is constructed in a cylinder shape and that the gas inlet openings (4), viewed in longitudinal axis direction of the equalizing chamber (2), are distributed axially uniformly.

4. A device according to one of the preceding claims, characterised in that the number of gas inlet openings (4) coincides with the number of consumers (14) and/or with the number of gas outlet openings (10).

5. A device according to one of the preceding claims, characterised in that at least one gas outlet opening (10) is associated with each gas inlet opening (4) and that respectively the distance between a gas inlet opening (4) and the gas outlet opening (10) associated therewith or the gas outlet openings (10) associated therewith is approximately of equal size.

6. A device according to one of the preceding claims, characterised in that the equalizing chamber (2) is constructed so as to be heatable.

7. A device according to one of the preceding claims, characterised in that the equalizing chamber (2) is constructed in a cylinder shape and the distance of adjacent gas inlet openings (4) lies in the region between 10 cm and 50 cm.

8. A device according to one of the preceding claims, characterised in that several gas streams, regulatable separately from each other, are able to be supplied simultaneously to the equalizing chamber (2) through each gas inlet opening (4).

9. A device according to one of the preceding claims, characterised in that for a number of different gas streams, respectively to be supplied to the gas consumers (14), an identical number of equalizing chambers (2) is provided.

## Revendications

1. Dispositif pour la répartition d'un courant de gaz en plusieurs courants partiels de gaz, comprenant une chambre de compensation (2) qui présente pour le courant de gaz une admission de gaz (15) munie de plusieurs orifices d'admission de gaz (4) et pour les courants partiels de gaz plusieurs orifices de sortie de gaz (10) reliés par une conduite de gaz (16) à un poste de consommation de gaz (14), la résistance hydraulique maximale (11) étant prévue vu dans le sens d'écoulement (8) des courants partiels de gaz dans la zone aval des orifices de sortie de gaz (10) pour chaque courant partiel de gaz, caractérisé en ce que la résistance hydraulique maximale (11) est prévue pour chaque courant partiel de gaz dans la conduite de gaz (16) entre l'orifice de sortie de gaz (10) et le poste de consommation de gaz (14) et en ce que les résistances hydrauliques (11) interviennent de manière interchangeable dans les conduites de gaz respectives (16).

2. Dispositif selon la revendication 1, caractérisé en ce que les résistances hydrauliques (11) sont respectivement conçues sous forme d'un composant métallique.

3. Dispositif selon l'une des revendications précédentes, caractérisé en ce que la chambre de compensation (2) a une forme cylindrique et en ce que les orifices d'admission de gaz (4) sont répartis régulièrement dans le sens longitudinal axial de la chambre de compensation (2), vu d'un point de vue axial.

4. Dispositif selon l'une des revendications précédentes, caractérisé en ce que le nombre des orifices d'admission de gaz (4) concorde avec le nombre des postes de consommation (14) et/ou avec le nombre des orifices de sortie de gaz (10).

5. Dispositif selon l'une des revendications précédentes, caractérisé en ce que chaque orifice d'admission de gaz (4) est au moins associé à un orifice de sortie de gaz (10) et en ce que la distance respective entre un orifice d'admission de gaz (4) et l'orifice de sortie de gaz (10) qui lui est associé ou les orifices de sortie de gaz (10) qui lui sont associés est approximativement identique.

6. Dispositif selon l'une des revendications précédentes, caractérisé en ce que la chambre de compensation (2) peut être munie d'un chauffage.

7. Dispositif selon l'une des revendications précédentes, caractérisé en ce que la chambre de compensation (2) est de forme cylindrique et en ce que la distance entre les orifices d'admission voisins (4) est comprise entre 10 cm et 50 cm.

8. Dispositif selon l'une des revendications précédentes, caractérisé en ce que plusieurs courants de gaz partiels réglables individuellement les uns des autres peuvent être amenés en même temps par chaque orifice d'admission de gaz (4) à la chambre de compensation (2).

9. Dispositif selon l'une des revendications précédentes, caractérisé en ce qu'il est prévu un nombre identique de chambres de compensation (2) à celui des divers courants de gaz à amener respectivement aux postes de consommation de gaz (14).
